Europäisches Patentamt

European Patent Office

Office européen des brevets

(11) Publication number: **0 398 170 A2**

# EUROPEAN PATENT APPLICATION

(21) Application number: **90108868.2**

(22) Date of filing: **11.05.90**

(51) Int. Cl.5: **H03K 17/04, H03K 17/687**

(30) Priority: **17.05.89 US 353123**

(43) Date of publication of application:
**22.11.90 Bulletin 90/47**

(84) Designated Contracting States:
**DE FR GB IT NL**

(71) Applicant: **NATIONAL SEMICONDUCTOR CORPORATION**
**2900 Semiconductor Drive P.O. Box 58090**
**Santa Clara California 95051-8090(US)**

(72) Inventor: **Hobrecht, Stephen W.**
**1590 Montebello Oaks Court**
**Los Altos, CA 94022(US)**

(74) Representative: **Sparing Röhl Henseler**
**Patentanwälte European Patent Attorneys**
**Rethelstrasse 123**
**D-4000 Düsseldorf 1(DE)**

(54) **Timed current boost for DMOST driver with rapid turn-on and low quiescent current.**

(57) A power DMOST driver employs a diff-amp gate driver that operates at a relatively low quiescent current when the DMOST is on. Means are included for switching the DMOST off and on in response to a control signal. When the DMOST is to be switched from off to on the diff-amp tail current is briefly raised to a substantially higher value so that the DMOST parasitic gate capacitance can quickly be driven to the on level. The tail current differential is large and determined by geometrically controlled IC quantities.

EP 0 398 170 A2

The invention relates to switched diffused metal oxide semiconductor transistor (DMOST) power devices. Such power DMOST devices are switched off by lowering their gate voltages and then raising the gate voltage to that level required by the conduction needed. Since the parasitic capacitance of a high power DMOST is substantial its driver must be capable of supplying a large transient current when it is to be switched on. In the interest of power economy the quiescent current in the driver should be low.

This application relates to a copending application which is titled INSTANTANEOUS POWER LIMITING CIRCUIT. It discloses an integrated circuit (IC) that is employed to drive a DMOST and employs means that sense the voltage across the DMOST as well as the current flowing. The circuit multiplies the voltage and current analogs together and includes means to hold the resulting power sense below a predetermined value. The teaching in this copending application is incorporated herein by reference.

Also, of interest is United States patent 4,803,612 which issued to Timothy V. Skovmand on February 7, 1989. This patent discloses a low dropout voltage regulator that employs a self-isolated DMOST as the pass transistor. Another related copending patent application by Timothy J. Skovmand, serial no. 189, 442 was filed May 12, 1988, and is titled VOLTAGE MULTIPLIER COMPATIBLE WITH A SELF-ISOLATED C/DMOS PROCESS. This application teaches a voltage multiplier operating from the system clock to achieve a voltage boost circuit for obtaining DMOST gate drive. The patent and patent application are both assigned to the assignee of the present invention and their respective teachings are incorporated herein by reference.

It is an object of the invention to provide a DMOST driver circuit capable to rapidly switch the DMOST from its off status into its on status inspite of a high parasite capacitance of the DMOST. Claim 1 defines the solution.

It further permits to operate the switched DMOST driver with a low quiescent current.

In accordance with the invention the current in a switched DMOST driver is controlled such that quiescent current is low and is multiplied by a substantial ratio immediately after the DMOST is switched on and remains at high current for a brief period thereafter.

A preferred embodiment operates as follows. A junction-isolated power DMOST is coupled between a supply source and an output terminal and means are provided for switching it off and on in response to a control signal. The DMOST.gate is driven from a differential amplifier (diff-amp) which has a controlled tail current. In the quiescent state, where the DMOST is on, the tail current is kept as low as is consistent with controlling the DMOST gate which displays a substantial parasitic capacitance. When the DMOST is to be turned on the diff-amp tail current is large relative to the current required to maintain the gate voltage under steady-state conditions. This current allows the diff-amp to charge the DMOST gate rapidly to provide fast driver turn on. After a brief period of time, the tail current is lowered to a quiescent value. The quiescent current is controlled by making the diff-amp tail current source part of a modified current mirror. The input to the mirror is developed as a controlled current that also flows in a resistor that develops a differential voltage ($\Delta V_{BE}$) between the two transistors in the modified current mirror. The ($\Delta V_{BE}$) can be controlled so that the current in the modified current mirror output is significantly lower than the input current. Thus, the quiescent current is kept low. A FET switch is connected between the two elements of the modified current mirror so that when it is turned on the $\Delta V_{BE}$ is bypassed and the current mirror is converted to a unity ratio circuit. Thus, for this condition, the diff-amp tail current is drastically increased to where it equals the current flowing in the input transistor. The FET gate is coupled to a potential source by way of a small capacitor that is driven from an amplifier that is in turn driven from the control signal. Thus, when the DMOST is to be turned on the capacitor couples a turn-on pulse to the gate of the FET switch which thereby turns on. The duration of the on state is controlled by means of a charging current for the capacitor. This time is kept small, but sufficient for the diff-amp to rapidly drive the DMOST gate to its desired potential. Once the capacitor becomes charged the FET switch turns off and a low quiescent current flow is generated.

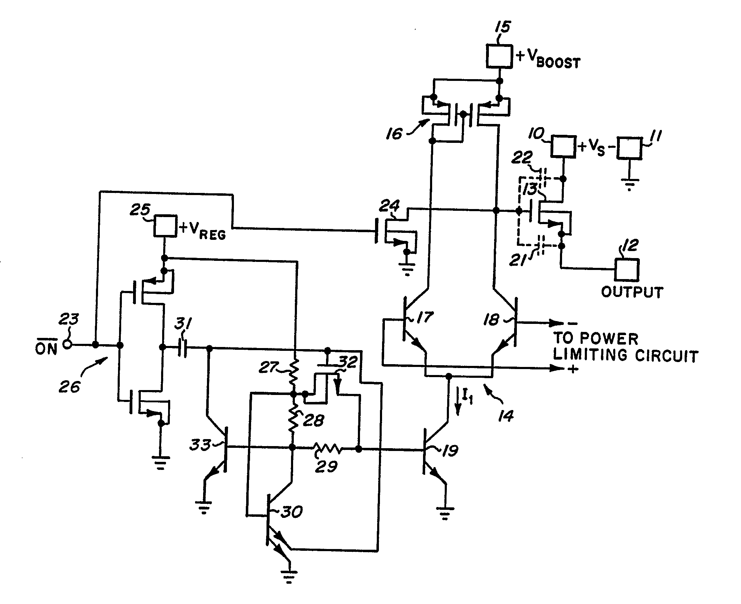

The single figure of drawing is a schematic diagram of the circuit of the invention.

In the following discussion the bipolar transistors are assumed to be of high Beta construction. Since the base currents are typically less than one percent of the related collector currents, the circuit analysis will regard the base currents as insignificant.

With reference to the drawing, a power supply, $V_S$, is connected + to terminal 10 and - to ground terminal 11. Output terminal 12 is intended to drive a load (not shown) connected between terminal 12 and ground DMOST 13 is an N channel junction-isolated power transistor of well known construction connected to source current out of terminal 12. The gate of DMOST 13 is driven from diff-amp 14 which includes a current mirror load 16 configured to provide a single ended output. Diff-amp 14 is operated from a $V_{BOOST}$ terminal 15 which is operated at a potential above $+V_S$ by a controlled increment. This "boost" action is needed for the condition where output terminal 12 can be driven to a potential that is close to $+V_S$. It has been found that a DMOST gate must be pulled up to well over the $+V_S$ level when such an output state is

2

required. These conditions are set forth in United States Patent 4,803,612.

Diff-amp 14 is composed of transistors 17 and 18 which are differentially connected. Their bases are driven from the power limiting circuit disclosed in the above-identified copending application The diff-amp 14 tail current $I_1$ is provided 19, the control of which will be described hereinafter.

The invention herein relates to speeding up the turn on of DMOST 13. As pointed out above, DMOST 13 is a power device and the typical form of construction involves the parallel connection of a large number of individual small area devices. This tends to produce large parasitic capacitance. For example, the gate to source capacitance 21 and gate to drain capacitance 22 comprise the gate capacitances associated with DMOST 13. Their values and behavior are well known in the prior art. The capacitances shown in the schematic are connected by dashed lines because they are actually parasitic in nature. The gate capacitance must be charged in order to switch the transistor on. A turn on speed up is achieved by momentarily increasing $I_1$, the diff-amp 14 tail cur rent, when the circuit is first turned on in response to the control signal.

The circuit is turned off and on by way of the ON terminal 23 which is directly connected to the gate of N channel transistor 24. When terminal 23 is high transistor 24 will be on and will pull the gate of DMOST 13 close to ground and thereby turn it off. In order to turn DMOST 13 on rapidly when terminal 23 goes from high to low, diff-amp 14 must supply a large current to the gate and this is done by momentarily increasing the tail current $I_1$. In the circuit shown in the preferred embodiment $I_1$ is increased by a factor of one hundred for a brief period of time. In effect a one-shot multivibrator action is invoked in the following manner.

The turn on speed up is powered from a $V_{REG}$ terminal 25 which is held at close to 5.2 volts by means of a conventional temperature stabilized voltage regulator circuit (not shown). The $V_{REG}$ supply operates a single stage inverter 26. Thus, the inverter output represents the ON signal which is high when the circuit is switched on. The $V_{REG}$ terminal 25 also supplies current to resistors 27-29 which are connected in.series to the base of transistor 19. Transistor 30 has its base connected to the juncture of resistors 27 and 28 and its collector connected to the juncture of resistors 28 and 29. Capacitor 31 couples the output of inverter 26 to the gate of N channel transistor 32 which has its controlled conduction electrodes connected to span resistors 28 and 29. Transistor 32 acts as a switch that is turned on when its gate is high and off when its gate is low. Transistor 33 has its collector connected to the gate of transistor 32, its emitter grounded and its base connected to the collector of transistor 30. Transistor 33, when turned on, provides a charging current path for capacitor 31. Transistor 30 has two emitters shown with one being grounded and the other connected to the gate of transistor 32.

Under quiescent conditions, the gate of transistor 32 will be low so that it is normally off. The current flowing in resistor 27 will pull the base of transistor 30 up to a $V_{BE}$ so as to turn it on. If $V_{REG}$ is at about 5.2 volts, as will be the case is the preferred embodiment, it can be seen that the voltage across resistor 27 will be about 4.5 volts. Thus, a 45k ohm resistor will pass about 100 microamperes which will flow largely in the collector of transistor 30. If resistor 28 is about 1.2k ohms, as preferred, it will produce a voltage drop of about 120 millivolts. Thus, the collector of transistor 30 will be at about 580 millivolts which is sufficient to turn transistors 19 and 33 on at a low level. (Note that both transistors 19 and 33 have their bases coupled to the collector of transistor 30.) The current flowing into the base of transistor 19 will be so small that no appreciable voltage drop occurs across resistor 29. If transistors 19, 30 and 33 are all of the same area the voltage drop across resistor 28 will introduce a $\Delta V_{BE}$ between transistor 30 and each of transistors 19 and 33. At 300$^\circ$k such a $\Delta V_{BE}$ will result in a relative current density of one hundred to one. Thus, one microampere will flow in transistor 19. The same value will try to flow in transistor 33 which will act to hold the gate of transistor 32 low.

When the circuit is to be switched on, by way of lowering the ON signal at terminal 23, a transient interval will be invoked as follows. It will be assumed that the circuit was off and is now being switched on. Thus, the gate of DMOST 13 was low and it is now to be pulled up so as to turn it on. At this point, the output of inverter 26 goes from low to high. Capacitor 31 will couple this positive transient to the gate of transistor 32 so as to turn it on fully. This switch action couples the base of transistor 19 directly to the base of transistor 30. Resistor 29 acts to isolate the base of transistor 19 from the collector of transistor 30 and base of 33 so as to leave the bias voltage at the base of 33 relatively constant. Since transistors 19 and 30 are of the same area, and since a 100 microampere current flows in transistor 30, transistor 19 will pass 100 microamperes which is 100 time its quiescent current. Thus, diff-amp 14 will have 100 times its quiescent current capability to vary the charge on the gate of DMOST 13 which will turn on very rapidly. While the current in transistor 19 is boosted in this transient condition, it can be seen that transistor 33 still has its base connected to the collector of transistor 30. Thus, transistor 33 will conduct its nominal one microampere which acts to charge capacitor 31 at a constant and hence linear rate. The capacitor charge will occur over a time period t (in microseconds) as follows:

$$t = \frac{C \Delta V}{I}$$

where: C is the capacitor value in picofarads;

$\Delta V$ is the change in charge in volts; and

I is the current in microamperes.

Thus, the preferred embodiment which employs a 9 pf capacitor will provide about a 30 microsecond transient timing. In such a time interval the parasitic capacitance 22 of DMOST 13 can be fully charged and the turn on completed.

It can be seen that after capacitor 31 is charged transistor 32 will turn off and the circuit will revert to its quiescent conditions and remain there as long as the circuit is on. However, if the circuit is subsequently switched off, capacitor 31 will attempt to drive the gate node of transistor 32 negative. Such a negative voltage in an IC is undesirable. This is where the second (or upper) emitter on transistor 30 comes into play. It will act to clamp the gate of transistor 32 at close to ground potential because it becomes conductive when it is driven to $V_{BE}$ below its base potential. Therefore, other than a brief period after the circuit is turned off, the second emitter in transistor 30 will be inactive.

## Example

The circuit of the drawing was constructed using a compatible CMOS/linear fabrication process which was based upon the conventional linear silicon, monolithic, planar, epitaxial, PN junction isolated form of construction. The DMOST power device was PN junction isolated and the other MOS devices were conventional. The following components were employed:

| COMPONENT | VALUE |
|---|---|
| Resistor 27 | 45k ohms |
| Resistor 28 | 1.2k ohms |
| Resistor 29 | 45k ohms |
| Capacitor 31 | 9 picofarads |

The NPN transistors all had Beta values in excess of 100. DMOST 13 had a series on resistance of about 0.8 ohms, a current capability of about 1 ampere and a total parasitic gate capacitance of about 175 pf. The supply voltage was about 12 volts and the $V_{BOOST}$ was about 32 volts. $V_{REG}$ was operated at about 5.2 volts. The transient interval was observed to be about 30 microseconds during which time DMOST 13 was being turned fully on. In terms of output drive, depending upon the load, the circuit could pull terminal 12 up to within 820 millivolts of $V_S$ during the transient interval.

The invention has been described, its operation detailed and a working example described. When a person skilled in the art reads the foregoing description, alternatives and equivalents, within the spirit and intent of the invention, will be apparent. Accordingly, it is intended that the scope of the invention be limited only by the following claims.

## Claims

1. A DMOST driver circuit in which a power DMOST, having substantial parasitic gate capacitance, is switched on and off in response to a control signal, said circuit comprising:

means, coupled to said DMOST gate, for providing the circuit off and on states in response to said control signal;

means for developing a transient interval, in response to said control signal, in the interval immediately following said control signal on state; and

means for increasing the gate drive of said DMOST during said transient interval whereby said DMOST turn on time is decreased.

2. The circuit of claim 1 wherein said increased gate drive is accomplished by means of a current source.

3. The circuit of claim 1 or 2 wherein said transient time period is controlled to provide sufficient time for said power DMOST parasitic capacitance to be driven to the turn on level.

4. The circuit of claim 2 wherein said gate drive operates by means of a diff-amp having a tail current supply comprising a first transistor having its base coupled to a second transistor operating as the current mirror input at a constant input current, means for operating said first transistor at a base voltage decrement lower than said second transistor wherein a $\Delta V_{BE}$ is developed so that said first transistor operates at a controlled lower current than said second transistor.

5. The circuit of claim 4 wherein a switch is incorporated into said circuit whereby said $\Delta V_{BE}$ decrement is bypassed when said switch is on and said first transistor operates at an increased current.

6. The circuit of claim 5 wherein said switch is turned on for a time increment immediately following the turn on of the driver.

7. The circuit of claim 6 wherein said time increment is created by means of a capacitor that charges through a third transistor which is operated at a controlled current.